# EUROPEAN PATENT SPECIFICATION

(11) **EP 2 209 941 B1**
(45) Date of publication and mention of the grant of the patent: **17.08.2016**
(21) Application number: 08849271.5
(22) Date of filing: 11.11.2008
(51) Int. Cl.: D06M 11/83, C23C 14/02, C23C 14/20, C23C 14/56

(54) **STAIN MASKING MATERIAL AND ARTICLES MADE THEREFROM**
FLECKENMASKIERENDE MATERIALIEN UND DARAUS HERGESTELLTE GEGENSTÄNDE
MATÉRIAU DE MASQUAGE DE TACHES ET OBJET RÉALISÉ EN CE MATÉRIAU

(30) Priority: 14.11.2007 US 3036
(43) Date of publication of application: 28.07.2010
(73) Proprietor: E. I. du Pont de Nemours and Company, Wilmington, DE 19898 (US)
(72) Inventor: BLETSOS, Ioannis, V., Midlothian Virginia 23113-3889 (US)
(74) Representative: Dannenberger, Oliver Andre
(86) International application number: PCT/US2008/083083
(87) International publication number: WO 2009/064706

(56) References cited:
- EP-A- 0 109 167
- WO-A-98/12494
- WO-A-2006/024013
- US-A- 5 241 149
- US-A1- 2007 000 568
- US-A1- 2007 037 465

## Description

### BACKGROUND OF THE INVENTION

### 1. Field of the Invention

The present invention relates to materials suitable for use in various types of applications including packages which mask stains, such as stains produced by oil-containing substances. The invention furthermore relates to articles incorporating the materials.

### 2. Description of the Related Art

Known air permeable materials for use in packaging applications include paper, nonwoven sheet, porous films, perforated films and laminates thereof. However, it has been found that when such packaging materials are exposed to grease-, fat- or oil-containing substances, such materials become discolored by visible oil stains which are undesirable and may be unacceptable to consumers or users of the packages.

Air permeable materials are used in a variety of packaging applications where the materials may come in contact with oil, grease or fat (also referred to herein as simply "oil"), including, for example, as the walls of oxygen-scavenging packets used to regulate the exposure of oxygen-sensitive products within a package to oxygen in order to preserve the freshness, quality and "shelf-life" of the products. By limiting the exposure of oxygen-sensitive food products to oxygen within a package, the quality or freshness of food is maintained, spoilage is reduced, and the food shelf life can be extended. In the food packaging industry, oxygen exposure can be regulated by including together with the items within a package (e.g., cans, jars, plastic containers, bags, etc.) air permeable oxygen-scavenging sachets or packets (also referred to as "oxygen scavenging packets") which contain a composition which scavenges the oxygen through oxidation reactions. The walls of such packets are air permeable so that oxygen can pass from outside the packet to the oxygen scavenging composition within the packet. Oxygen scavenging packets are used within packages of oily foods where they may become visibly stained.

Air permeable materials are also used in protective apparel applications in which an article of apparel is worn as personal protection during activities which result in staining of the apparel. Typically the apparel article is discarded solely because of the staining, while the functionality of the article has not been affected by the staining. It would be desirable to reduce the appearance of stains so that the useful life of the article can be extended.

It would be desirable to have a material suitable for applications including, but not limited to, the above applications which masks the appearance of stains, such as, but not limited to, oil stains, resulting from contact of the material with staining substances during use.

### SUMMARY OF THE INVENTION

According to the present invention, there is provided the use of a metalized substrate comprising (i) a porous substrate having an inner surface and an outer surface, and (ii) a discontinuous metal layer deposited on at least the outer surface of the porous substrate, the metalized substrate having a gloss of at least about 2 gloss units when measured at an angle of illumination of 20°, for masking the appearance of stains in an article produced therefrom, wherein the gloss is measured according to ASTM D2457-03.

Preferred embodiments are as described in claims 2 and 3.

Further described herein are:
(1) An oxygen-scavenging packet suitable for contact with oil-containing substances, wherein the packet comprises (a) a plurality of side walls having inner and outer surfaces and defining an enclosed space wherein each side wall comprises a metalized sheet comprising (i) a porous substrate having inner and outer surfaces, and (ii) a discontinuous metal layer deposited on the outer surface of the substrate; wherein the metalized sheet has a gloss at an angle of illumination of 20° greater than about 2 gloss units, a Gurley Hill porosity of less than about 20,000 seconds, and wherein the appearance of staining on the outer surfaces of the side walls is masked; and (b) an oxygen absorber within the enclosed space of the packet.
(2) A package for enclosing an article comprising (a) a plurality of side walls having inner and outer surfaces and defining an enclosed space suitable for containing the article wherein each side wall comprises a metalized sheet comprising (i) a porous substrate having inner and outer surfaces, and (ii) a discontinuous metal layer deposited on the outer surface of the substrate; wherein the metalized sheet has a gloss at an angle of illumination of 20° greater than about 2 gloss units, and wherein the appearance of staining on the outer surfaces of the side walls is masked.
(3) An article of apparel comprising a metalized substrate having inner and outer surfaces and a discontinuous metal layer deposited on the outer surface of the substrate; wherein the metalized substrate has a gloss at an angle of illumination of 20° greater than about 2 gloss units, a Frazier air permeability of at least about 0.1 cfm/ft² (0.03048 m³/m²·min) and a moisture vapor transmission rate in the range of 1000-3000 g/m²/24 hr, and wherein the appearance of staining on the outer surface of the metalized substrate is masked.
(4) An article for dressing wounds comprising a metalized substrate having an inner surface and an outer surface and a discontinuous metal layer deposited on the outer surface of the substrate; wherein the metalized substrate has a gloss at an angle of illumination of 20° greater than about 2 gloss units, Frazier air permeability of at least about 0.1 cfm/ft² (0.03048 m³/m²min), and wherein the appearance of staining on the outer surface of the metalized substrate is masked.

### DETAILED DESCRIPTION OF THE INVENTION

The invention is directed to the use of a metalized substrate including a porous substrate and a discontinuous metal layer deposited thereon, the metalized substrate having a gloss of at least about 2 gloss units when measured at an angle of illumination of 20°. The metalized substrate masks the appearance of stains, particularly stains caused by oil. The discontinuous metal layer is deposited on at least one surface of the porous substrate on which it is desirable to mask the appearance of stains.

Substrates for use as the porous substrate include woven fabrics, spunbond nonwovens, spunbonded-meltblown-spunbonded composite nonwovens, spunlaced nonwovens, nonwovens including submicron fibers such as electrospun or electroblown web, microporous film, paper, microperforated film and laminates thereof. Suitable woven fabrics, spunbond nonwovens, spunbonded-meltblown-spunbonded composite nonwovens can be formed from synthetic filaments such as polyester, polyamide and polyolefin filaments. Suitable microporous films can be formed from polymers such as, for example, polyester, polyamide, polycarbonate, vinyl, polyolefins and fluorinated polymers. Desirable properties of the substrate will vary depending on the embodiment of the invention.

Metals for use in the metal layer include aluminum, silver, copper, gold, tin, nickel, zinc, iron, and their alloys including aluminum bronze alloys, manganese bronze alloys, copper/nickel/zinc alloys, copper/nickel alloys, stainless steel, and aluminum/magnesium alloys. The metal layer can have a thickness between about 15 nanometers and 200 nanometers. Alternatively, the metal layer can be formed from a plurality of superimposed metal layers wherein each metal layer has the same or different metal composition relative to the other metal layers. The metal layer is discontinuous as the metal layer does not completely cover the pores of the substrate.

The discontinuous metal layer can be left uncoated or coated as desired for the application. According to one embodiment of the invention, use in a package is provided which masks the appearance of stains. In packaging applications in which the package will come in contact with food, the metal layer can be coated by a thin layer of an FDA- approved polymer such as a polyacrylate which is advantageously also printable. The metalization of the porous substrate and subsequent coating can economically be carried out in a single pass using a vapor deposition process as disclosed in co-pending U.S. Patent Application having Serial Number 10/924,218, filed on August, 23, 2004. The metallization can be carried out by thermal evaporation, sputtering or other metal deposition technologies known in the art. The metal layer may be passivated and the coating on top of it may occur in a different step sometime after metallization. If the surface of the polyacrylate coating is printed on, a second coating can be applied over the ink to prevent the printing ink from contacting the food and also from wearing or fading.

Packages can be formed from a plurality of side walls of the packaging material of the invention defining an enclosed space suitable for containing an article or a plurality of articles. Packages can be formed from material which is air permeable and which regulates the exposure of items or materials to oxygen or moisture. Packages made from such air permeable materials are referred to as "intelligent" or "active" packaging systems. The package can include a heat sealable layer located on surfaces where the side walls are adhered to each other, e.g., a layer of low density polyethylene, polypropylene or copolymers of ethylene and vinyl acetate. The amount of the heat sealable layer can also be used to regulate the air permeability of the package.

According to another embodiment of the invention, use in an oxygen scavenging packet is provided which masks the appearance of stains. The oxygen scavenging packet has a plurality of side walls defining an enclosed space to contain an oxygen absorber composition. The oxygen scavenging packet can utilize a metalized substrate in each of the side walls of the packet or in fewer than all of side walls of the packet and an air impermeable material can be used in the remainder of the side walls. The air permeable material used in oxygen scavenging packets of the invention has an air permeability of less than 20,000 Gurley seconds. This permeability regulates the rate of oxygen that can be absorbed by the absorber within the packet. This determines the useful life of the packet which in turn influences the shelf life of the oxygen-sensitive contents the oxygen scavenging packet is intended to protect. Oxygen scavenging packets are formed from side wall materials such as the packaging material described herein, using any known process for forming the packets including "form-fill-seal" processes in which tubes or other enclosures of the packaging material are formed continuously while the packaging material is unwound from a roll. Once the tube is formed, cross machine direction seals are formed in the tube creating three sided pouches which are then filled with the contents of the packet. The packets are finally sealed completely. Oxygen absorbers for use in the oxygen scavenging packet of the invention include any known oxygen absorber compositions, such as those disclosed in U.S. Patent Number 5,241,149.

According to another embodiment of the invention, use is provided in articles of apparel, bedding, diapers and sanitary articles which mask the appearance of stains and can advantageously be formed from a metalized porous substrate. For instance, medical garments and protective apparel items formed from substrates having a discontinuous layer of metal deposited on the outer surface mask the appearance of oil stains, blood stains, etc. For such uses, the substrate is advantageously selected from woven fabrics, spunbond nonwovens, spunlaced nonwovens, nonwovens including submicron fibers, spunbonded-meltblown-spunbonded composite nonwovens, and laminates thereof. The substrate has a Frazier air permeability from about 0.1 to more than about 100 cfm/ft² (about 0.03048 m³/m²·min to more than about 30.48 m³/m²·min) and a moisture vapor transmission rate in the range of 1000-3000 g/m²/24 hr.

According to another embodiment of the invention, use is provided in wound dressing materials which can be formed from a metalized substrate in which a discontinuous layer of metal is deposited onto one surface of a porous substrate ("outer surface"). When the non-metalized surface of the substrate ("inner surface") is placed directly over a wound, stains caused by blood and other fluids including topical treatments applied to the wound are not visible on the outer surface of the wound dressing. The wound dressing materials can also be used in adhesive bandages. For this use, the substrate is advantageously selected from woven fabrics, spunbond nonwovens, spunlaced nonwovens, nonwovens including submicron fibers, spunbonded-meltblown-spunbonded composite nonwovens, and laminates thereof. The substrate has a Frazier air permeability from about 0.1 to more than about 100 cfm/ft² (about 0.03048 m³/m²·min to more than about 30.48 m³/m²·min) and a moisture vapor transmission rate in the range of 1000-3000 g/m²/24 hr.

According to another embodiment of the invention, use is provided in stationery and graphics items which mask stains, including, but not limited to, envelopes, shipping pouches, substrates for graphic images, maps, business cards, banners, etc. For this use, suitable substrates advantageously have a tensile strength of at least about 20 lb/in (3503 N/m) according to ASTM D5035, even between about 20 lb/in (3503 N/m) and about 72 lb/in (12259 N/m), and an elongation of at least about 14% according to ASTM D5035, even between about 14% and about 29%. Suitable substrates advantageously include spunbond nonwovens, film, paper, and laminates thereof.

According to yet another embodiment of the invention, use is provided in sheets which masks stains and which are useful in agricultural sheet applications such as mulches and sheet used to reflect solar radiation and facilitate the drying of raisins. For these uses, suitable substrates advantageously have a tensile strength of at least about 20 lb/in (3503 N/m) according to ASTM D5035, even between about 20 lb/in (3503 N/m) and about 72 lb/in (12259 N/m), and an elongation of at least about 14% according to ASTM D5035, even between about 14% and about 29%, reflectivity in the visible and infrared spectra, and high UV durability. Suitable substrates for such uses advantageously include woven fabrics, spunbond nonwovens, film, paper and laminates thereof.

### TEST METHODS

Gloss was measured according to ASTM D2457-03 at an angle of illumination of 20°.

### EXAMPLES

Two rolls of high density polyethylene spunbond nonwoven sheet commercially available from E. I. du Pont de Nemours & Co. (Wilmington, Delaware) under the trade name DuPont™ Tyvek® (style 1560B) were treated with an 80% argon/20% nitrogen plasma in vacuum and were subsequently metalized with a discontinuous layer of aluminum using resistive evaporation. Both steps were done in a single pass. One roll was metalized on one side only (designated "single metal") and the other roll was metalized on both sides (designated "double metal"). Neither roll was coated after metallization. The resulting "single metal" roll had a shiny metalized side and a white side. The "double metal" roll had two shiny metalized sides that could be distinguished from each other by the original surface patterns of the Tyvek® sheet, in which one side was relatively smooth and the other side was relatively rough.

Samples of the "single metal" and the "double metal" Tyvek® rolls were folded as follows:
Example 1: Single metal sample, metalized side folded onto metalized side.
Example 2: Single metal sample, white side folded onto white side.
Example 3: Double metal sample, rough metalized side folded onto rough metalized side.

Three pieces of pepperoni of equal thickness were placed side by side within the fold of each of the three samples as described above and completely covered on each side by the samples. In Example 1 the metalized surface contacts the pepperoni slices; in Example 2 the white, non-metalized surface contacts the pepperoni slices; and in Example 3 the rough, metalized surface contacts the pepperoni slices. A 5 lb (2.3 kg) weight was placed on top of each folded sample with the pepperoni pieces inside the fold to press oil from the pepperoni slices into direct contact with the surrounding samples. The weight was left in place on each sample for approximately 10 hours. The weight was removed, the samples were unfolded and the pieces of pepperoni were removed to observe the stain on the metalized Tyvek® samples.

In the single-sided metalized samples, regardless of whether the pepperoni was in contact with the white (non-metalized) or the metalized side, the white side showed a circular oily stain surrounded by a reddish "halo." No oil stain or reddish halo was observed on the metalized side, regardless of whether the pepperoni was in contact with the white or metalized side. Similarly, in the double-sided metalized samples, regardless of whether the pepperoni was in contact with the smooth or rough side, no oily stain or reddish halo was observed on either side.

The gloss at an angle of illumination of 20° was measured for each side of each sample, both outside the circular area ("outside") which was covered by the weight and inside the circular area ("inside"), and the results are listed in Table 1. Each gloss measurement listed is the average of the gloss of the surface above the pepperoni slices and the gloss of the surface below pepperoni slices. The percent difference in gloss was calculated as the percent difference between the gloss outside the circular area and the gloss inside the circular area relative to the gloss unaffected by the stain, i.e., outside the circular area.

Control sample gloss measurements were also taken on clean samples having no contact with the pepperoni. Control 1 was a clean "single metal" sample. Control 2 was a clean "double metal" sample.

**Table 1**

| | | Gloss | % Difference in Gloss |
|---|---|---|---|
| Control 1 | Metalized surface | 5.5 | |
| | Non-metalized surface | 1.5 | |
| Example 1 | Outside, metalized surface | 4.9 | 14 |
| | Inside, metalized surface | 4.2 | |
| | Outside, non-metalized surface | 1.2 | 17 |
| | Inside, non-metalized surface | 1.0 | |
| Example 2 | Outside, metalized surface | 5.4 | 8.4 |
| | Inside, metalized surface | 4.9 | |
| | Outside, non-metalized surface | 1.6 | 35 |
| | Inside, non-metalized surface | 1.0 | |
| Control 2 | Rough metalized surface | 3.1 | |
| | Smooth metalized surface | 5.4 | |
| Example 3 | Outside, rough metalized surface | 3.0 | 15 |
| | Inside, rough metalized surface | 2.5 | |
| | Outside, smooth metalized surface | 5.4 | 6.5 |
| | Inside, smooth metalized surface | 5.0 | |

The metalized surfaces have higher gloss than the non-metalized white sides and they hide the appearance of the oil stain. In both the metalized sides and the white sides of the above samples, the gloss is reduced inside the circular area which was covered by the weight, however the reduction of gloss by the oily stain is significantly greater on the white, non-metalized surface than on the metalized surfaces of the Examples.

## Claims

1. Use of a metalized substrate comprising
(i) a porous substrate having an inner surface and an outer surface, and
(ii) a discontinuous metal layer deposited on at least the outer surface of the porous substrate, the metalized substrate having a gloss of at least about 2 gloss units when measured at an angle of illumination of 20°,
for masking the appearance of stains in an article produced therefrom,
wherein the gloss is measured according to ASTM D2457-03.

2. The use of claim 1, wherein the stain is caused by oil.

3. The use of claim 1, wherein the article is
(i) an oxygen-scavenging packet suitable for contact with oil-containing substances, wherein the packet comprises (a) a plurality of side walls having inner and outer surfaces and defining an enclosed space wherein each side wall comprises said metalized substrate, and (b) an oxygen absorber within the enclosed space of the packet, wherein the metal layer is deposited on the outer surface of the substrate, and the metalized substrate preferably has a Gurley Hill porosity of less than about 20,000 seconds,
(ii) a package for enclosing an article comprising a plurality of side walls having inner and outer surfaces and defining an enclosed space suitable for containing the article to be enclosed, wherein each side wall comprises said metalized substrate, wherein the metal layer is deposited on the outer surface of the substrate,
(iii) an article of apparel, wherein the metal layer is deposited on the outer surface of the substrate, and the metalized substrate has a Frazier air permeability of at least about 0.1 cfm/ft² (0.03048 m³/m²·min) and a moisture vapor transmission rate in the range of 1000-3000 g/m²/24 hr, or
(iv) an article for dressing wounds, wherein the metal layer is deposited on the outer surface of the substrate, and the metalized substrate has a Frazier air permeability of at least about 0.1 cfm/ft² (0.03048 m³/m²·min).

## Patentansprüche

1. Verwendung eines metallisierten Substrats umfassend
(i) ein poröses Substrat, dass eine Innenfläche und eine Außenfläche aufweist, und
(ii) eine diskontinuierliche Metallschicht, die auf mindestens der Außenfläche des porösen Substrats aufgebracht ist, wobei das metallisierte Substrat einen Glanz von mindestens etwa 2 Glanzeinheiten aufweist, wenn er in einem Beleuchtungswinkel von 20° gemessen wird, zum Maskieren des Auftretens von Flecken in einem daraus hergestellten Artikel, wobei der Glanz ASTM D2457-03 entsprechend gemessen wird.

2. Verwendung nach Anspruch 1, wobei der Fleck durch Öl verursacht wird.

3. Verwendung nach Anspruch 1, wobei der Artikel Folgendes ist
(i) eine Sauerstoff aufnehmende Verpackung, die für den Kontakt mit ölhaltigen Substanzen geeignet ist, wobei die Verpackung (a) eine Mehrzahl von Seitenwänden, die Innen- und Außenflächen aufweisen und einen eingeschlossenen Raum definieren, wobei jede Seitenwand das metallisierte Substrat umfasst, und (b) einen Sauerstoffabsorber innerhalb des eingeschlossenen Raums der Verpackung umfasst, wobei die Metallschicht auf der Außenfläche des Substrats aufgebracht ist und das metallisierte Substrat bevorzugt eine Gurley Hill-Porosität von weniger als etwa 20.000 Sekunden aufweist,
(ii) eine Verpackung zum Einschließen eines Artikels, die eine Mehrzahl von Seitenwänden umfasst, die Innen- und Außenflächen aufweisen und einen eingeschlossenen Raum definieren, der zum Halten des Artikels, der eingeschlossen werden soll, geeignet ist, wobei jede Seitenwand das metallisierte Substrat umfasst, wobei die Metallschicht auf der Außenfläche des Substrats aufgebracht ist,
(iii) ein Kleidungsstück, wobei die Metallschicht auf der Außenfläche des Substrats abgesetzt ist und das metallisierte Substrat eine Frazier-Luftdurchlässigkeit von mindestens etwa 0,1 cfm/ft² (0,03048 m³/m²·min) und eine Wasserdampfdurchlässigkeitsrate im Bereich von 1000-3000 g/m²/24 h aufweist oder
(iv) ein Artikel zum Verbinden von Wunden, wobei die Metallschicht auf der Außenfläche des Substrats aufgebracht ist und das metallisierte Substrat eine Frazier-Luftdurchlässigkeit von mindestens etwa 0,1 cfm/ft² (0,03048 m³/m²·min) aufweist.

## Revendications

1. Utilisation d'un substrat métallisé comprenant
(i) un substrat poreux ayant une surface interne et une surface externe, et
(ii) une couche de métal discontinue déposée sur au moins la surface externe du substrat poreux, le substrat métallisé ayant un brillant d'au moins environ 2 unités de brillance lorsque mesuré sous un angle d'éclairage de 20°, pour le masquage de l'apparence des taches dans un article produit à partir de celui-ci, où le brillant est mesuré selon la norme ASTM D2457-03.

2. Utilisation selon la revendication 1, dans laquelle la tache est provoquée par de l'huile.

3. Utilisation selon la revendication 1, dans laquelle l'article est
(i) un paquet d'épuration d'oxygène convenant au contact avec les substances contenant de l'huile, où le paquet comprend (a) une pluralité de parois latérales ayant des surfaces internes et externes et définissant un espace clos où chaque paroi latérale comprend ledit substrat métallisé, et (b) un agent d'absorption d'oxygène à l'intérieur de l'espace clos du paquet, où la couche de métal est déposée sur la surface externe du substrat, et le substrat métallisé présente de préférence une porosité de Gurley Hill inférieure à environ 20 000 secondes,
(ii) un paquet pour enfermer un article comprenant une pluralité de parois latérales ayant des surfaces internes et externes et définissant un espace clos convenant à l'enfermement de l'article à enfermer, où chaque paroi latérale comprend ledit substrat métallisé, où la couche de métal est déposée sur la surface externe du substrat,
(iii) un article de vêtement, où la couche de métal est déposée sur la surface externe du substrat, et le substrat métallisé présente une perméabilité à l'air de Frazier d'au moins environ 0,1 cfm/pi² (0,03048 m³/m²·min) et un taux de transmission de la vapeur humide situé dans la plage de 1 000 à 3 000 g/m²/24 h, ou
(iv) un article de pansement des plaies, où la couche de métal est déposée sur la surface externe du substrat, et le substrat métallisé présente une perméabilité à l'air de Frazier d'au moins environ 0,1 cfm/pi² (0,03048 m³/m²·min).
